# DEMANDE DE BREVET EUROPEEN

(11) **EP 4 297 548 A1**
(43) Date de publication de la demande: **27.12.2023**
(21) Numéro de dépôt: 23177440.7
(22) Date de dépôt: 06.06.2023
(51) Int. Cl.: H10B 63/10, H10N 70/20

(54) **PROCEDE DE FABRICATION DE DISPOSITIFS ELECTRONIQUES**

(30) Priorité: 16.06.2022 FR 2205853
(71) Demandeur: STMicroelectronics Crolles 2 SAS, 38920 Crolles (FR)
(72) Inventeur: BERTHELON, Remy, 38400 SAINT MARTIN D'HERES (FR); WEBER, Olivier, 38000 GRENOBLE (FR)
(74) Mandataire: Cabinet Beaumont

(57) **Abrégé**

La présente description concerne un procédé de fabrication d'un dispositif comprenant une première partie (A-A, B-B) dans laquelle est formée une matrice de cellules mémoire et une deuxième partie (SOI) dans laquelle sont formés des transistors, le procédé comprenant :
a. la formation de premières tranchées isolantes (20) séparant les unes des autres les régions (22c) de substrat d'une même ligne de cellules, et
b. la formation de deuxièmes tranchées (18) séparant les unes des autres les régions (22c) d'une même colonne de cellules, les deuxième tranchées (18) ayant une hauteur supérieure à la hauteur des premières tranchées (20),
l'étape a. comprenant les formations indépendantes d'une partie inférieure (40) et d'une partie supérieure (46, 54) de chaque première tranchée,
la formation des parties supérieures comprenant le dépôt d'une première couche isolante, la gravure des portions de la première couche isolante n'étant pas situées sur les parties inférieures.

## Description

### Domaine technique

La présente description concerne de façon générale les procédés de fabrication de dispositifs électroniques, et plus particulièrement de dispositifs comprenant des cellules mémoire.

### Technique antérieure

Les dispositifs électroniques comprenant des mémoires comprennent par exemple des matrices de cellules mémoire. Les matrices de cellules mémoire comprennent des lignes et des colonnes de cellules mémoire, les cellules d'une même ligne étant reliées par une ligne de bit et les cellules d'une même colonne étant reliées par une ligne de mot.

### Résumé de l'invention

Un mode de réalisation pallie tout ou partie des inconvénients des procédés de fabrication de dispositifs électroniques connus.

Un mode de réalisation prévoit un procédé de fabrication d'un dispositif comprenant une première partie dans laquelle est formée une matrice de cellules mémoire et une deuxième partie dans laquelle sont formés des transistors, chaque cellule mémoire étant située sur une région d'un substrat, le procédé comprenant les étapes suivantes :
la formation de premières tranchées isolantes séparant les unes des autres les régions de substrat d'une même ligne de cellules, et
la formation de deuxièmes tranchées séparant les unes des autres les régions de substrat d'une même colonne de cellules, les deuxièmes tranchées ayant une hauteur supérieure à la hauteur des premières tranchées,
l'étape a. comprenant les étapes suivantes :
   a1. la formation d'une partie inférieure de chaque première tranchée, et
   a2. la formation d'une partie supérieure de chaque première tranchée,
la formation des parties supérieures comprenant le dépôt d'une première couche isolante et la gravure des portions de la première couche isolante n'étant pas situées sur les parties inférieures.

Selon un mode de réalisation, le substrat est de type substrat sur isolant dans la deuxième partie du dispositif.

Selon un mode de réalisation, le procédé comprend, avant les étapes a. et b., une étape c. de retrait, dans la première partie, de la couche supérieure de semiconducteur d'un substrat de type substrat sur semiconducteur et la croissance du matériau isolant de la couche intermédiaire isolante du substrat de type substrat sur semiconducteur sur une hauteur au moins égale à la hauteur de la couche supérieure de semiconducteur du substrat, la couche intermédiaire étant en un premier matériau isolant.

Selon un mode de réalisation, le procédé comprend, avant les étapes a. et b. et après l'étape c., l'étape d. de formation de la première couche sur les première et deuxième parties.

Selon un mode de réalisation, l'étape a2. comprend la formation de premières ouvertures dans la première couche en regard des emplacements des régions, et l'étape a1. comprend la gravure de la couche intermédiaire à travers les premières ouvertures, l'étape a2. comprenant, après l'étape a1, le retrait des portions de la première couche situées dans la deuxième partie, la première couche étant en un deuxième matériau isolant.

Selon un mode de réalisation, l'étape a2. comprend le retrait des portions de la première couche situées hors de la première partie et le retrait des portions de la couche intermédiaire et de la première couche situées aux emplacements des premières tranchées, la première couche étant en le premier matériau isolant.

Selon un mode de réalisation, le procédé comprend, après l'étape a. et avant l'étape b., une étape e. de croissance de la couche inférieure du substrat de type semiconducteur sur isolant aux emplacements des régions.

Selon un mode de réalisation, le procédé comprend, après l'étape e., une étape f. de formation d'un empilement comprenant une deuxième couche en le premier matériau et une troisième couche en le deuxième matériau sur les première et deuxième parties.

Selon un mode de réalisation, les premier et deuxième matériaux sont gravables sélectivement l'un par rapport à l'autre.

Selon un mode de réalisation, le premier matériau est de l'oxyde de silicium et le deuxième est du nitrure de silicium.

Selon un mode de réalisation, l'étape b. comprend, après l'étape f., la formation de deuxièmes ouvertures dans la troisième couche de l'empilement en regard des emplacements des deuxièmes tranchées, la formation de cavités à travers les deuxièmes ouvertures, et la formation, sur les première et deuxièmes parties, d'une quatrième couche en le premier matériau suffisamment épaisse pour remplir les cavités.

Selon un mode de réalisation, le procédé comprend, après l'étape b, une étape g. de retrait par polissage mécano-chimique des portions de la quatrième couche situées au-dessus de la troisième couche de l'empilement et une étape h. de retrait de la troisième couche.

Selon un mode de réalisation, le procédé comprend, après l'étape h., des étapes de dopage du substrat.

Selon un mode de réalisation, le procédé comprend le dépôt de bandes de silicium sur les parties supérieures des premières tranchées.

Un autre mode de réalisation prévoit un dispositif comprenant une première partie dans laquelle est disposée une matrice de cellules mémoire et une deuxième partie dans laquelle sont disposés des transistors, chaque cellule mémoire étant située sur une région d'un substrat, le dispositif comprenant des premières tranchées isolantes séparant les unes des autres les régions de substrat d'une même ligne de cellules, et des deuxièmes tranchées séparant les unes des autres les régions de substrat d'une même colonnes de cellules, les deuxième tranchées ayant une hauteur supérieure à la hauteur des premières tranchées, dans lequel les faces supérieures des premières et deuxièmes tranchées sont séparées d'une distance inférieure à 10 nm.

Un autre mode de réalisation prévoit un dispositif comprenant une première partie dans laquelle est disposée une matrice de cellules mémoire et une deuxième partie dans laquelle sont disposés des transistors, chaque cellule mémoire étant située sur une région d'un substrat, le dispositif comprenant des premières tranchées isolantes séparant les unes des autres les régions de substrat d'une même ligne de cellules, et des deuxièmes tranchées séparant les unes des autres les régions de substrat d'une même colonnes de cellules, les deuxième tranchées ayant une hauteur supérieure à la hauteur des premières tranchées, dans lequel chaque première tranchée comprend une partie inférieure en un premier matériau et une partie inférieure en un deuxième matériau différent du premier matériau, les deuxièmes tranchées ne comprenant pas le deuxième matériau.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 représente schématiquement une vue de dessus d'une matrice de cellules mémoire ;
la figure 2A représente une vue en coupe du dispositif de la figure 1 dans la direction d'une ligne de mot ;
la figure 2B représente une vue en coupe du dispositif de la figure 1 dans la direction d'une ligne de bit ;
les figure 3A, figure 3B, figure 3C, figure 3D, figure 3E, figure 3F, figure 3G, figure 3H représentent des étapes, de préférences successives, d'un procédé de fabrication d'un dispositif électroniques ; et
les figure 4A, figure 4B, figure 4C, figure 4D, figure 4E, figure 4F, figure 4G, figure 4H représentent des étapes, de préférences successives, d'un autre procédé de fabrication d'un dispositif électroniques.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

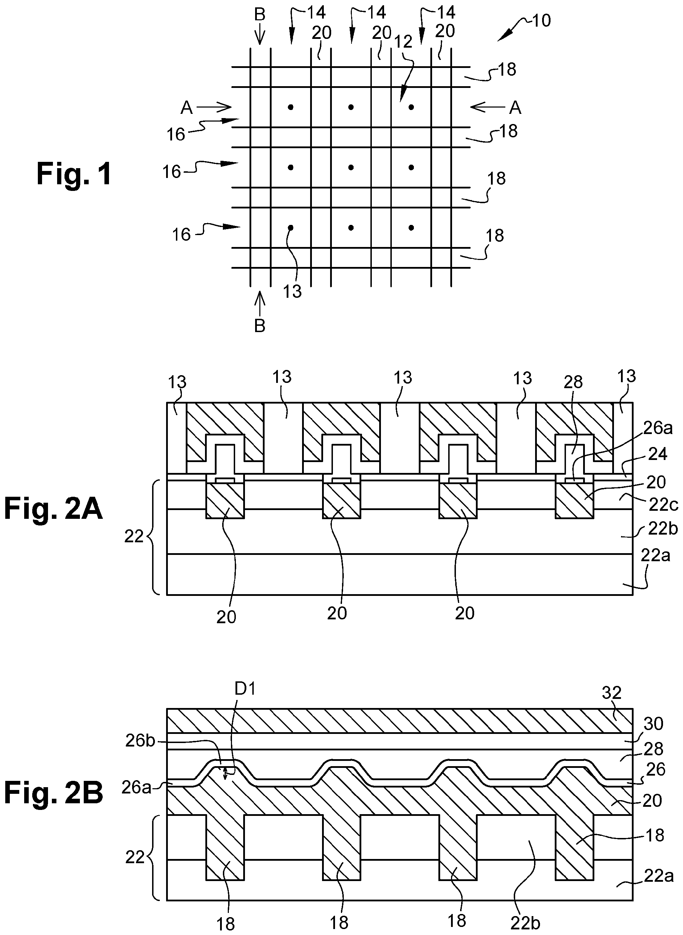

La figure 1 représente schématiquement une vue de dessus d'un dispositif électronique comprenant une matrice 10 de cellules mémoire 12.

Les cellules 12 sont formées sur un même substrat non représenté en figure 1. Chaque cellule mémoire comprend par exemple un via 13 reposant sur le substrat et sur lequel repose le reste de la cellule. Les cellules mémoire sont par exemple des cellules mémoire à changement de phase. Ainsi, chaque cellule comprend une couche non représentée de matériau à changement de phase. Ladite couche est par exemple située entre deux couches métalliques non représentée, la couche inférieure reposant par exemple sur le via 13 de la cellule.

La matrice 10 comprend une pluralité de colonnes 14 de cellules mémoire 12 et une pluralité de lignes 16 de cellules mémoire 12. Seulement trois lignes et trois colonnes sont représentées en figure 1.

Les différentes lignes 16 de cellules mémoire sont séparées les unes des autres par des tranchées isolantes peu profondes (Shallow Trench Insulation - STI) 18. Chaque ligne 16 de cellules mémoire est ainsi séparée de chaque ligne 16 voisine par une tranchée 18.

Les différentes colonnes 14 de cellules mémoire sont séparées les unes des autres par des tranchées isolantes très peu profondes (Super Shallow Trench Insulation - SSTI) 20. Chaque colonne 14 de cellules mémoire est ainsi séparée de chaque colonne 14 voisine par une tranchée 20.

Autrement dit, les lignes 16 et les tranchées 18 s'étendent dans une même direction, par exemple la direction de la ligne de bit, et sont donc sensiblement parallèles les unes aux autres. Similairement, les colonnes 14 et les tranchées 20 s'étendent dans une même direction, par exemple la direction de la ligne de mot, et sont donc sensiblement parallèles les unes aux autres. La direction dans laquelle s'étendent les tranchées 18 et la direction dans laquelle s'étendent les tranchées 20 sont sensiblement orthogonales. En vue de dessus, c'est-à-dire dans le plan de la figure 1, la direction dans laquelle s'étendent les tranchées 18 et la direction dans laquelle s'étendent les tranchées 20 sont sensiblement perpendiculaires.

Le dispositif comprend par exemple une puce comprenant divers composants électroniques. La matrice mémoire 10 est par exemple située sur la puce. Par exemple, la puce sur laquelle est située la matrice 10 comprend le substrat, la matrice située sur une région du substrat, et des composants, par exemple des composants logiques, situés dans une autre région du substrat. Les composants comprennent, par exemple en majorité, des transistors. Les transistors, et éventuellement d'autres composants situés autour de la matrice, comprennent du silicium polycristallin, par exemple dans la grille des transistors. Lors de la fabrication d'une puce, il est utile d'assurer que la densité de silicium polycristallin n'est pas trop inégale. Pour ce faire, des lignes de silicium polycristallin non représentée en figure 1 sont par exemple placées dans les matrices mémoire. Par exemple, une ligne de silicium polycristallin est par exemple située sur chaque tranchée 20. De préférence, les lignes de silicium polycristallin ne sont pas utilisées dans le dispositif pour d'autres fonctions que l'homogénéisation de la densité de silicium polycristallin. De préférence, les lignes de silicium polycristallin ne sont pas reliées électriquement à des composants électroniques autres qu'elles-mêmes.

La figure 2A représente une vue en coupe du dispositif de la figure 1 dans la direction d'une ligne de mot. La figure 2B représente une vue en coupe du dispositif de la figure 1 dans la direction d'une ligne de bit. Plus précisément, la figure 2A représente une vue en coupe du dispositif de la figure 1 dans le plan A-A de la figure 1 et la figure 2B représente une vue en coupe du dispositif de la figure 1 dans le plan B-B de la figure 1.

Le dispositif comprend un substrat 22. Le substrat 22 est un substrat semiconducteur, par exemple en silicium. Le substrat 22 comprend par exemple une région 22a inférieure dopée d'un premier type de conductivité, par exemple dopée de type P. Le substrat 22 comprend par exemple une région 22b intermédiaire, dopée d'un deuxième type de conductivité, par exemple dopée de type P. La région 22b recouvre, de préférence entièrement, la région 22a.

Le substrat 22 comprend des régions 22c supérieures. Chaque cellule mémoire est située sur une, de préférence une unique, région 22c. Les régions 22c forment ainsi une matrice correspondant à la matrice de cellules mémoire. La matrice de régions 22c comprend ainsi des lignes s'étendant dans la même direction que les lignes de la matrice de cellules mémoire et des colonnes s'étendant dans la même direction que les colonnes de la matrice de cellules mémoire. La matrice de régions 22c comprend ainsi des lignes s'étendant en regard des lignes de la matrice de cellules mémoire et des colonnes s'étendant en regard des colonnes de la matrice de cellules mémoire. Les régions 22c de la matrice sur lesquelles sont situées les régions 22c sont par exemple dopées du premier type de conductivité. Par exemple, certaines régions 22c, par exemple des régions sur lesquelles aucune cellule mémoire n'est située, sont dopées du deuxième type de conductivité et sont en contact avec un via, de manière à fournir une tension à la région 22b.

Les régions 22c d'une même ligne de la matrice de régions 22c sont séparées les unes des autres par les tranchées 20. Les tranchées 20 s'étendent de la face supérieure des régions 22c, en particulier de la face supérieure des régions 22c voisines, à la région 22b. Les tranchées 20 s'étendent au moins sur toute la hauteur des régions 22c. Les tranchées 20 s'étendent par exemple sur une partie de la hauteur de la région 22b.

Les régions 22c d'une même colonne de la matrice de régions 22c sont séparées les unes des autres par les tranchées 18. Les tranchées 18 s'étendent de la face supérieure des régions 22c, en particulier de la face supérieure des régions 22c voisines, à la région 22a. Les tranchées 18 s'étendent au moins sur toute la hauteur des régions 22b et 22c. Les tranchées 18 s'étendent par exemple sur une partie de la hauteur de la région 22a.

Les régions 22c sont de préférence chacune recouverte d'une couche métallique 24. Les couches 24 recouvrent de préférence uniquement la face supérieure des régions 22c. Les vias 13 reposent chacun sur une couche 24. Ainsi, les vias 13 sont reliées électriquement aux régions 22c par les couches 24. Ainsi, un courant peut être fourni à chaque cellule mémoire, en particulier au via 13 de chaque cellule, par l'intermédiaire de la région 22c et de la couche 24 correspondant à cette cellule.

Le dispositif comprend en outre des bandes métalliques 26. Les bandes 26 sont par exemple en nitrure de titane. Une bande 26 est située sur chaque tranchée 20. Les bandes 26 s'étendent de préférence sur toute la longueur de la matrice, dans la direction des tranchées 20. Ainsi, les bandes 26 s'étendent par exemple sur toute la longueur des tranchées 20.

La largeur des bandes 26 est inférieure à la largeur des tranchées 20. Par largeur des bandes 26, on entend la dimension des bandes 26 dans la direction allant d'une paroi latérale d'une tranchée 20 à l'autre paroi latérale, c'est-à-dire dans la direction d'une ligne de mot.

Chaque bande 26 est recouverte d'une couche 28 de silicium polycristallin. Chaque bande 26 est de préférence recouverte entièrement par la couche 28. Ainsi, la bande 26 est entièrement enterrée entre la tranchée 20 et la couche 28. Les couches 28 permettent d'homogénéiser la densité de silicium polycristallin dans le dispositif. Autrement dit, les couches 28 permettent d'assurer que la différence de densité de silicium polycristallin entre la matrice mémoire et les zones comprenant les transistors n'est pas trop élevée pour permettre la fabrication du dispositif.

Chaque couche 28 est recouverte d'une couche 30 isolante électriquement, par exemple en nitrure de silicium. La couche 30 est par exemple recouverte d'une couche 32 isolante électriquement, par exemple en oxyde de silicium. Les vias 13 sont par exemple entièrement entourés latéralement par les couches isolantes 30 et 32.

Dans les procédés de fabrication connus, les étapes de fabrication des tranchées 18 et 20 entraînent la formation de tranchées 18 et 20 ayant des faces supérieures non coplanaires. Ainsi, les bandes 26 déposées sur les tranchées 20 ne sont pas planes. Chaque bande 26 comprend par exemple des portions 26a étant situées dans un plan inférieur et des portions 26b situées dans un plan supérieur. La distance D1 entre les plans inférieur et supérieur est par exemple comprise entre 10 nm et 30 nm. Les portions 26a sont par exemple adjacentes aux régions 22c et les portions 26b sont par exemple adjacentes aux tranchées 18. Ainsi, les régions 22c sont séparées les unes des autres par des portions de tranchées 20 sur lesquelles reposent des portions 26a.

Comme cela est représenté en figure 2A, les portions 26a sont proches des régions 22c et des couches 24. Par exemple, le plan inférieur dans lequel sont situées les portions 26a est par exemple dans le plan des couches 24 ou dans un plan inférieur, c'est-à-dire dans un plan comprenant les régions 22c. Le risque d'interférence entre les bandes 26 et les régions 22c et les couches 24 est donc important. En effet, la distance entre chaque portion de matériau isolant située entre une bande 26 et les régions 22c voisines, ou les couches 24 voisines, risque d'être suffisamment faible pour permettre la formation d'un courant entre les régions 22c voisines, ou les couches 24 voisines, par l'intermédiaire de la bande 26. La lecture et la programmation des cellules mémoire seraient alors perturbées.

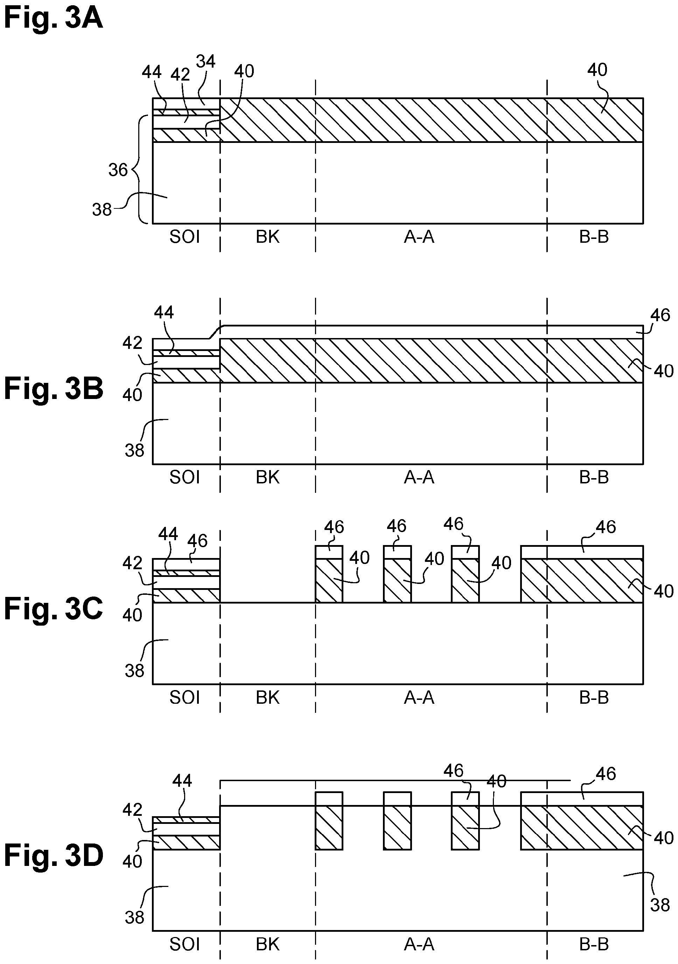

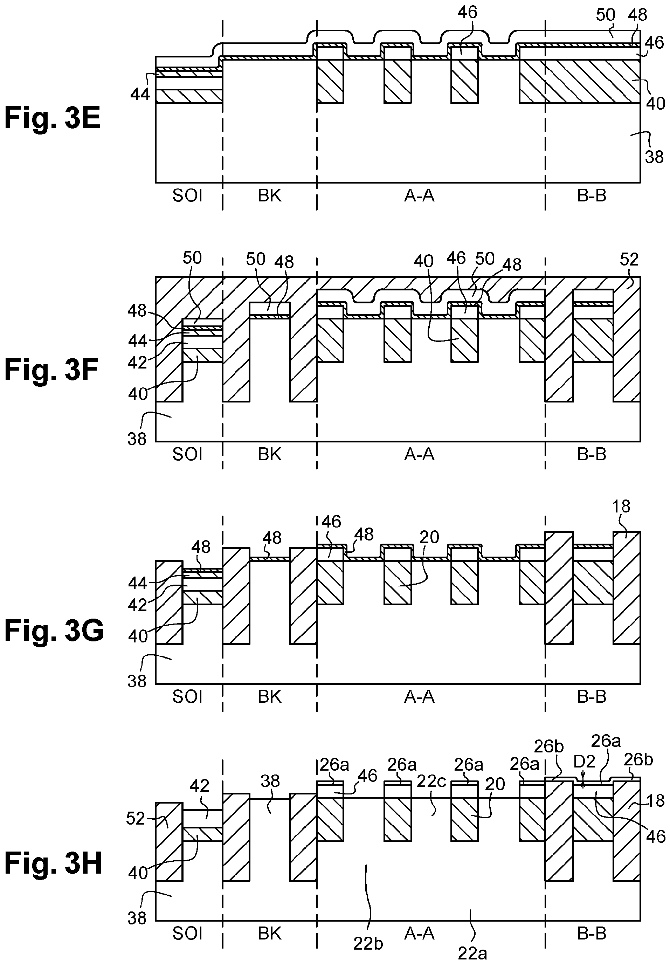

Les figure 3A, figure 3B, figure 3C, figure 3D, figure 3E, figure 3F, figure 3G, figure 3H représentent des étapes, de préférences successives, d'un procédé de fabrication d'un dispositif électronique comprenant des cellules mémoire. Les figures 3A à 3H comprennent :
une première partie représentant les étapes dans une partie SOI du dispositif comprenant des composants, par exemple des composants logiques, formés sur une portion de type semiconducteur sur isolant (SOI - Semiconductor On Insulator) d'un substrat ;
une deuxième partie représentant les étapes dans une partie massive ("bulk" en anglais) BK du dispositif comprenant des composants, par exemple des composants logiques, formés sur une portion de substrat massif du substrat ;
une troisième partie A-A représentant une partie A-A du dispositif comprenant une matrice mémoire dans le plan de coupe A-A, c'est-à-dire le plan de la figure 2A ; et
une quatrième partie B-B représentant la partie B-B du dispositif comprenant une matrice mémoire dans le plan de coupe B-B, c'est-à-dire le plan de la figure 2B. Les première, deuxième et troisième parties sont situées sur un même substrat.

Au cours de l'étape résultant en la structure de la figure 3A, un masque de gravure 34 est formé sur un substrat 36 de type semiconducteur sur isolant (SOI) dans la partie SOI du substrat. Le substrat 36 comprend une couche semiconductrice inférieure 38, par exemple en silicium, une couche isolante 40, par exemple en oxyde de silicium, recouvrant la couche 38, et une couche semiconductrice supérieure 42, par exemple en silicium. Le masque 34 est par exemple en nitrure de silicium. Une couche 44 en oxyde de silicium est par exemple formée sur la couche 42 avant la formation du masque 34. Le masque 34 est ainsi par exemple séparé de la couche 42 par la couche 44.

Le masque 34 est formé de manière à avoir des ouvertures au niveau des parties du substrat correspondant aux parties BK et A-A, B-B de la figure 3A.

Les couches 42 et 44 sont ensuite gravées à travers les ouvertures dans le masque 34. Ainsi, les couches 42 et 44 sont retirées des parties du substrat correspondant aux parties BK et A-A, B-B de la figure 3A.

La couche 40 subit ensuite une étape de croissance. Au cours de cette étape, la couche 40 dans les parties du substrat correspondant aux parties BK et A-A, B-B de la figure 3A croît jusqu'à atteindre un niveau supérieur au niveau de la face supérieure de la couche 44 de la partie SOI, par exemple jusqu'à atteindre le niveau de la face supérieure de la couche 34. Dans l'exemple de la figure 3A, la face supérieure de la couche 34 dans la partie SOI et la face supérieure de la couche 40 dans les parties BK et A-A, B-B sont coplanaires.

Au cours de l'étape résultant en la structure de la figure 3B, le masque 34 est retiré. Une couche 46 en un matériau pouvant être gravé sélectivement par rapport au matériau de la couche 40 est formée sur la structure, c'est-à-dire sur la couche 40, dans les parties BK, A-A, B-B, et sur la couche 44 dans la partie SOI. Par gravable sélectivement, on entend qu'il existe un procédé de gravure avec lequel le matériau de la couche 46 est gravé au moins deux fois plus vite que le matériau de la couche 40. La couche 46 est par exemple en nitrure de silicium. De préférence, les matériaux des couches 40 et 46 sont gravables sélectivement l'une par rapport à l'autre.

Au cours de l'étape résultant en la structure de la figure 3C, des ouvertures sont formées dans la couche 46 de manière à ce que la couche 46 forme un masque de gravure.

En particulier, une ouverture est formée en regard de la partie BK, c'est-à-dire la partie du substrat formant un substrat massif, et en regard des emplacements des régions 22c de la partie A-A, B-B.

La couche 40 est ensuite gravée à travers les ouvertures. Ainsi, la couche 40 est retirée des parties BK et des emplacements des régions 22c.

Au cours de l'étape résultant en la structure de la figure 3D, la couche 38 subit une étape de croissance. Plus précisément, les portions de la couche 38 découvertes lors de l'étape de la figure 3C subissent une étape de croissance. Ainsi, la couche 38 s'étend, dans la partie BK et aux emplacements des régions 22c, dans les ouvertures formées au cours de l'étape de la figure 3C. De préférence, la couche 38 s'étend, dans la partie BK et aux emplacements des régions 22c, jusqu'à un niveau supérieur au niveau de la face supérieure de la couche 42. Par exemple, la couche 38 s'étend, dans la partie BK et aux emplacements des régions 22c, jusqu'au niveau de la face supérieure de la couche 40 dans la partie A-A, B-B. La face supérieure de la couche 38 dans la partie BK et aux emplacements des régions 22c est par exemple coplanaire avec la face supérieure de la couche 40 dans la partie A-A, B-B.

La portion de la couche 46 située dans la partie SOI est ensuite retirée. Ainsi, à la suite des étapes des figures 3C et 3D, la couche 46 est entièrement retirée, à l'exception des portions situées sur les portions de la couche 40 de la partie A-A, B-B, qui correspondent aux tranchées 20 situées dans la matrice mémoire. Cela correspond donc à une étape de sur-élèvement des portions de la couche 40 de la partie A-A, B-B, qui correspondent aux tranchées 20 situées dans la matrice mémoire. Ainsi, chaque tranchée 20 comprend une portion inférieure, formée par une portion de la couche 40, et une portion supérieure, formée par une portion de la couche 46.

Au cours de l'étape résultant en la structure de la figure 3E, un empilement d'une couche isolante 48 et d'une couche isolante 50 est formé sur la structure résultant de l'étape de la figure 3D.

La couche 48 est formée de manière conforme sur la structure. La couche 48 recouvre ainsi, de préférence entièrement, la couche 44 de la partie SOI. Plus précisément, la couche 48 recouvre ainsi, de préférence entièrement, la face supérieure de la couche 44 de la partie SOI. La couche 48 recouvre, de préférence entièrement, la couche 38 de la partie BK. Plus précisément, la couche 48 recouvre, de préférence entièrement, la face supérieure de la couche 38 de la partie BK. La couche 48 recouvre, de préférence entièrement, les portions de la couche 46 et la couche 38 de la partie A-A, B-B. Plus précisément, la couche 48 recouvre, de préférence entièrement, la face supérieure de la couche 38 de la partie A-A, B-B, la face supérieure de la couche 38 de la partie A-A, B-B, et les faces supérieures et latérales des portions de la couche 46 de la partie A-A, B-B.

La couche 50 recouvre, de préférence entièrement la couche 48. Les portions de la couche 46 n'ayant pas été retirées par la gravure de l'étape de la figure 3D, c'est-à-dire les portions de la couche 46 situées sur les portions de la couche 40 formant les tranchées 20, sont séparées de la couche 50 par la couche 48.

De préférence, la couche 48 est en le même matériau que la couche 40. La couche 48 est par exemple en oxyde de silicium.

La couche 50 est par exemple en le même matériau que la couche 46. La couche 50 est par exemple en nitrure de silicium. La couche 50 est en un matériau gravable sélectivement par rapport au matériau de la couche 48.

L'épaisseur de la couche 50 est telle que le niveau, ou plan, de la partie de la face supérieure de la couche 50 la plus proche de la couche 38 est séparée de la couche 38 par le niveau de la partie de la face supérieure de la couche 48 la plus éloignée de la couche 38. Autrement dit, le niveau de la partie de la face supérieure de la couche 50 la plus proche de la couche 38 est uniquement recouvert de portions de la couche 50.

Au cours de l'étape résultant en la structure de la figure 3F, des ouvertures sont formées dans la couche 50, constituant un masque de gravure, en regard des emplacements des tranchées peu profondes (STI) . Des tranchées peu profondes peuvent être formées dans les parties SOI, BK et A-A, B-B. En particulier, dans la partie A-A, B-B, c'est-à-dire dans la partie de la puce dans laquelle est formée la matrice mémoire, les tranchées peu profondes comprennent les tranchées 18 des figures 2A et 2B. Les tranchées peu profondes ont par exemple toutes sensiblement la même profondeur. Une étape de gravure est ensuite effectuée à travers lesdites ouvertures dans la couche 50 de manière à former des cavités aux emplacements des tranchées 18.

Dans la partie SOI, les portions des couches 38, 40, 42, 44 et 48 situées aux emplacements des tranchées peu profondes sont gravées à travers les ouvertures dans la couche 50. Ainsi, les couches 40, 42, 44 et 48 sont de préférence entièrement traversées par les cavités formées par la gravure. La couche 38 est de préférence partiellement traversée par les cavités formées par la gravure.

Dans la partie BK, les portions des couches 38 et 48 situées aux emplacements des tranchées peu profondes sont gravées à travers les ouvertures dans la couche 50. Ainsi, la couche 48 est de préférence entièrement traversée par les cavités formées par la gravure. La couche 38 est de préférence partiellement traversée par les cavités formées par la gravure.

Dans la partie A-A, B-B, c'est-à-dire dans la partie dans laquelle est formée la matrice mémoire, les portions des couches 38, 40, 46 et 48 situées aux emplacements des tranchées peu profondes 18 sont gravées à travers les ouvertures dans la couche 50. Ainsi, les couches 40, 46 et 48 sont de préférence entièrement traversées par les cavités formées par la gravure. La couche 38 est de préférence partiellement traversée par les cavités formées par la gravure.

Une couche 52 est formée sur la structure. L'épaisseur de la couche 52 est telle que la couche 52 remplit les cavités formées aux emplacements des tranchées peu profondes et recouvre, de préférence entièrement, la couche 50.

La couche 52 est en un matériau isolant électriquement, par exemple en oxyde de silicium. De préférence, la couche 52 est en le même matériau que la couche 48. De préférence, la couche 52 est en le même matériau que la couche 40.

Au cours de l'étape résultant en la structure de la figure 3G, la structure subit une étape de polissage, par exemple par un procédé de polissage mécano-chimique. Le procédé de polissage est effectué de manière à découvrir, de préférence entièrement la couche 50.

Dans la partie SOI, la portion de la couche 52 située au-dessus du niveau de la face supérieure de la couche 50 est par exemple retirée. La face supérieure du dispositif dans la partie SOI est donc plane et comprend la face supérieure de la couche 50 entourée latéralement par la face supérieure de la couche 52.

Dans la partie BK, la portion de la couche 52 située au-dessus du niveau de la face supérieure de la couche 50 est par exemple retirée. La face supérieure du dispositif dans la partie BK est donc plane et comprend la face supérieure de la couche 50 entourée latéralement par la face supérieure de la couche 52.

Dans la partie A-A, B-B, les couches 50 et 52 sont polis jusqu'à retirer tout le matériau de la couche 52 situé au-dessus de la couche 50. Ainsi, les couches 50 et 52 sont retirées jusqu'au niveau de la partie de la couche 50 la plus proche de la couche 38.

Les portions de la couche 50 sont ensuite retirées par un procédé de gravure sélective du matériau de la couche 50 par rapport au matériau de la couche 48 et du matériau de la couche 52. Ainsi, le plan de la face supérieure des tranchées peu profondes est séparé du plan de la face supérieure de la couche 48 par une hauteur correspondant sensiblement à l'épaisseur de la couche 50.

Au cours de l'étape résultant en la structure de la figure 3H, diverses étapes de fabrication de composant électroniques peuvent être effectuées. En particulier, des étapes de dopage de matériau semiconducteur sont effectuées. La couche 42 de la partie SOI et la couche 38 de la partie BK sont par exemple dopées de manière à former des composants électroniques, en particulier des transistors. Similairement, la couche 38 de la partie A-A, B-B est dopée de manière à former les régions 22a, 22b et 22c.

Les étapes de dopage comprennent par exemple la formation et le retrait de masques, par exemple des masques de lithophotographie. Ces étapes entraînent le retrait partiel du matériau de la couche 48 et des tranchées peu profondes. Ainsi, la couche 48 est retirée au cours de ces étapes. De préférence, l'épaisseur de la couche 48 est telle que la couche 48 est entièrement retirée. Les portions de la couche 46 situées sur les tranchées 20 ne sont pas retirées. De plus, la hauteur des tranchées peu profondes, en particulier les tranchées 18 de la matrice mémoire, est diminuée par les étapes de formation et de retrait de masques.

Les bandes 26 sont ensuite formées sur les portions de la couche 46 situées sur des portions de la couche 40. La couche 28, non représentée en figure 3H, en silicium polycristallin est ensuite formée sur la structure.

La présence, et le maintien, des portions de la couche 46 permettent de diminuer la distance entre les portions 26a et 26b. Ainsi, les plans inférieur et supérieur, c'est-à-dire les parties 26a et 26b, sont séparés par une distance D2, inférieure à la distance D1. Autrement dit, les faces supérieures des tranchées 18 et 20 sont séparées par la distance D2. La distance D2 est par exemple inférieure à 10 nm. De plus, les portions 26a sont plus fortement séparées des régions 22c, ce qui permet d'éviter les fuites de courant.

Les cellules mémoire sont ensuite formées sur les régions 22c. En particulier, des vias 13 sont ensuite formés sur les régions 22c.

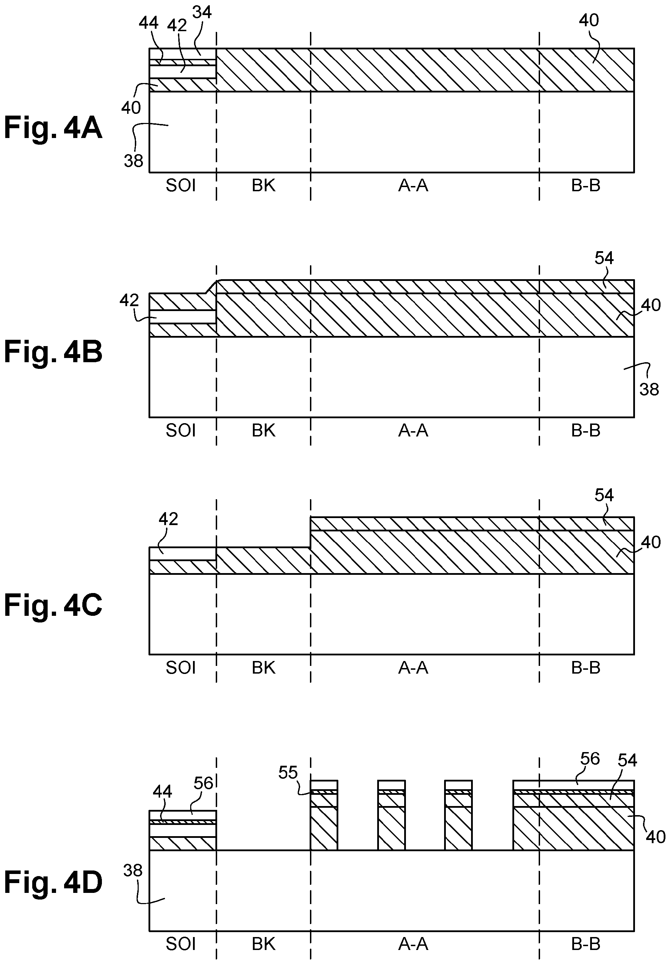

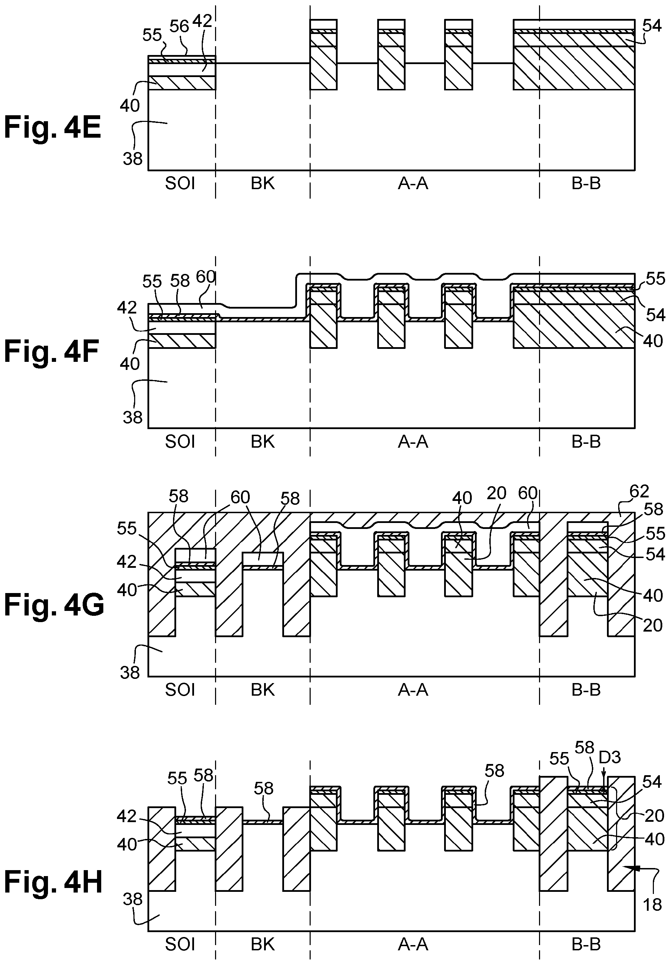

Les figure 4A, figure 4B, figure 4C, figure 4D, figure 4E, figure 4F, figure 4G, figure 4H représentent des étapes, de préférence successives, d'un autre procédé de fabrication d'un dispositif électronique.

Au cours de l'étape résultant en la structure de la figure 4A, comme au cours de l'étape résultant en la structure de la figure 3A, un masque de gravure 34 est formé sur un substrat 36 de type semiconducteur sur isolant (SOI). Le substrat 36 comprend une couche semiconductrice inférieure 38, par exemple en silicium, une couche isolante 40, par exemple en oxyde de silicium, recouvrant la couche 38, et une couche semiconductrice supérieure 42, par exemple en silicium. Le masque 34 est par exemple en nitrure de silicium. Une couche 44 en oxyde de silicium est par exemple formée sur la couche 42 avant la formation du masque 34. Le masque 34 est ainsi par exemple séparé de la couche 42 par la couche 44.

Le masque 34 est formé de manière à avoir des ouvertures au niveau des parties du substrat correspondant aux parties BK, A-A, B-B de la figure 3A.

Les couches 42 et 44 sont ensuite gravées à travers les ouvertures dans le masque 34. Ainsi, les couches 42 et 44 sont retirées des parties du substrat correspondant aux parties BK, A-A, B-B de la figure 3A.

La couche 40 subit ensuite une étape de croissance. Au cours de cette étape, la couche 40 dans les parties du substrat correspondant aux parties BK, A-A, B-B de la figure 3A croît jusqu'à atteindre un niveau supérieur au niveau de la face supérieure de la couche 44 de la partie SOI, par exemple jusqu'à atteindre le niveau de la face supérieure de la couche 34. Dans l'exemple de la figure 3A, la face supérieure de la couche 34 dans la partie SOI et la face supérieure de la couche 40 dans les parties BK, A-A, B-B sont coplanaires.

Au cours de l'étape résultant en la structure de la figure 4B, le masque 34 et la couche 44 sont retirés. Une couche 54 est formée sur la structure, c'est-à-dire sur la couche 40, dans les parties BK, A-A, B-B, et sur la couche 44 dans la partie SOI. La couche 54 est de préférence en le même matériau que la couche 40. La couche 54 est par exemple en oxyde de silicium.

Au cours de l'étape résultant en la structure de la figure 4C, les portions des couches 40 et 54 situées, dans les parties SOI et BK, au-dessus du plan de la face supérieure de la couche 42 sont retirées. Les couches 40 et 54 ne sont pas gravées dans la partie A-A, B-B, c'est-à-dire la partie correspondant à la matrice mémoire.

Cela correspond donc à une étape de sur-élèvement des portions de la couche 40 de la partie A-A, B-B, qui correspondent aux tranchées 20 situées dans la matrice mémoire.

Au cours de l'étape résultant en la structure de la figure 4D, une couche 55 est formée sur la structure. La couche 55 est en un matériau isolant, de préférence en le même matériau que la couche 40, par exemple en oxyde de silicium. La couche 55 recouvre la couche 42 dans la partie SOI, la couche 38 dans la partie BK et la couche 54 dans la partie A-A, B-B.

La couche 55 est recouverte, de préférence entièrement, d'une couche 56 en un matériau pouvant être gravé sélectivement par rapport au matériau des couches 40 et 54. La couche 46 est par exemple en nitrure de silicium.

Des ouvertures sont formées dans la couche 56 de manière à ce que la couche 56 forme un masque de gravure. En particulier, une ouverture est formée en regard de la partie BK, c'est-à-dire la partie du substrat formant un substrat massif, et en regard des emplacements des régions 22c de la partie A-A, B-B.

Les couches situées entre la couche 56 et la couche 38, c'est-à-dire le substrat, sont ensuite gravées à travers les ouvertures. Ainsi, la couche 40 est retirée de la partie BK. De plus, les portions des couches 40, 54, et 55 situées en regard des ouvertures, c'est-à-dire aux emplacements des régions 22c, sont gravées.

Au cours de l'étape résultant en la structure de la figure 4E, la couche 38 subit une étape de croissance. Plus précisément, les portions de la couche 38 découvertes lors de l'étape de la figure 4D subissent une étape de croissance. Ainsi, la couche 38 s'étend, dans la partie BK et aux emplacements des régions 22c, dans les ouvertures formées au cours de l'étape de la figure 4D. De préférence, la couche 38 s'étend, dans la partie BK et aux emplacements des régions 22c, jusqu'au niveau de la face supérieure de la couche 42 dans la partie SOI. La face supérieure de la couche 38 dans la partie BK et aux emplacements des régions 22c est par exemple coplanaire avec la face supérieure de la couche 42 dans la partie SOI.

Au cours de l'étape résultant en la structure de la figure 4F, la portion de la couche 56 située dans la partie SOI est ensuite retirée. Ainsi, à la suite des étapes des figures 4E et 4F, la couche 56 a été entièrement retirée, à l'exception des portions situées sur les portions de la couche 40 de la partie A-A, B-B, qui correspondent aux tranchées 20 situées dans la matrice mémoire.

De plus, une couche 58 est formée sur la structure. La couche 58 est en un matériau isolant, de préférence en le même matériau que la couche 40, par exemple en oxyde de silicium. La couche 58 recouvre la couche 55 dans la partie SOI, la couche 35 dans la partie BK et la couche 55 dans la partie A-A, B-B.

La couche 58 est recouverte, de préférence entièrement, d'une couche 60 en un matériau pouvant être gravé sélectivement par rapport au matériau des couches 40 et 58. La couche 60 est par exemple en nitrure de silicium.

L'épaisseur de la couche 60 est telle que le niveau, ou plan, de la partie de la face supérieure de la couche 60 la plus proche de la couche 38 est séparé de la couche 38 par le niveau de la partie de la face supérieure de la couche 58 la plus éloignée de la couche 38. Autrement dit, le niveau de la partie de la face supérieure de la couche 60 la plus proche de la couche 38 est uniquement recouvert de portions de la couche 60.

Au cours de l'étape résultant en la structure de la figure 4G, des ouvertures sont formées dans la couche 60, constituant un masque de gravure, en regard des emplacements des tranchées peu profondes (STI) . Des tranchées peu profondes peuvent être formées dans les parties SOI, BK et A-A, B-B. En particulier, dans la partie A-A, B-B, c'est-à-dire dans la partie de la puce dans laquelle est formée la matrice mémoire, les tranchées peu profondes comprennent les tranchées 18 des figures 2A et 2B. Les tranchées peu profondes ont par exemple toutes sensiblement la même profondeur. Une étape de gravure est ensuite effectuée à travers lesdites ouvertures dans la couche 60 de manière à former des cavités aux emplacements des tranchées 18.

Dans la partie SOI, les portions des couches 38, 40, 42, 55 et 58 situées aux emplacements des tranchées peu profondes sont gravées à travers les ouvertures dans la couche 60. Ainsi, les couches 40, 42, 55 et 58 sont de préférence entièrement traversées par les cavités formées par la gravure. La couche 38 est de préférence partiellement traversée par les cavités formées par la gravure.

Dans la partie BK, les portions des couches 38 et 58 situées aux emplacements des tranchées peu profondes sont gravées à travers les ouvertures dans la couche 60. Ainsi, la couche 58 est de préférence entièrement traversée par les cavités formées par la gravure. La couche 38 est de préférence partiellement traversée par les cavités formées par la gravure.

Dans la partie A-A, B-B, c'est-à-dire dans la partie dans laquelle est formée la matrice mémoire, les portions des couches 38, 40, 54, 55 et 58 situées aux emplacements des tranchées peu profondes 18 sont gravées à travers les ouvertures dans la couche 60. Ainsi, les couches 40, 54, 55 et 58 sont de préférence entièrement traversées par les cavités formées par la gravure. La couche 38 est de préférence partiellement traversée par les cavités formées par la gravure.

Une couche 62 est formée sur la structure. L'épaisseur de la couche 62 est telle que la couche 62 remplie les cavités formées aux emplacements des tranchées peu profondes et recouvre, de préférence entièrement, la couche 60.

La couche 62 est en un matériau isolant électriquement, par exemple en oxyde de silicium. De préférence, la couche 62 est en le même matériau que la couche 58. De préférence, la couche 62 est en le même matériau que la couche 40.

Au cours de l'étape résultant en la structure de la figure 4H, la structure subit une étape de polissage, par exemple par un procédé de polissage mécano-chimique. Le procédé de polissage est effectué de manière à découvrir, de préférence entièrement, une face supérieure de la couche 60.

Dans la partie SOI, la portion de la couche 62 située au-dessus du niveau de la face supérieure de la couche 60 est par exemple retirée. La face supérieure du dispositif dans la partie SOI est donc plane et comprend la face supérieure de la couche 60 entourée latéralement par la face supérieure de la couche 62.

Dans la partie BK, la portion de la couche 62 située au-dessus du niveau de la face supérieure de la couche 60 est par exemple retirée. La face supérieure du dispositif dans la partie BK est donc plane et comprend la face supérieure de la couche 60 entourée latéralement par la face supérieure de la couche 62.

Dans la partie A-A, B-B, les couches 60 et 62 sont polis jusqu'à retirer tout le matériau de la couche 62 situé au-dessus de la couche 60. Ainsi, les couches 60 et 62 sont retirées jusqu'au niveau de la partie de la couche 60 la plus proche de la couche 38. La face supérieure du dispositif dans la partie A-A, B-B est donc plane et comprend la face supérieure de la couche 60 entourée latéralement par la face supérieure de la couche 62. Aucune portion de la couche 60 dans la partie A-A, B-B n'est séparée de la face supérieure du dispositif par une portion de la couche 62.

Les portions de la couche 60 sont ensuite retirées par un procédé de gravure sélective du matériau de la couche 60 par rapport au matériau de la couche 58 et du matériau de la couche 62. Ainsi, le plan de la face supérieure des tranchées peu profondes 18 est séparé du plan de la face supérieure de la couche 58 par une hauteur correspondant sensiblement à l'épaisseur de la couche 60.

Le procédé comprend, en outre, à la suite de l'étape décrite en relation avec la figure 4H, une étape au cours de laquelle diverses étapes de fabrication de composants électroniques peuvent être effectuées. En particulier, des étapes de dopage de matériau semiconducteur sont effectuées.

La couche 42 de la partie SOI et la couche 38 de la partie BK sont par exemple dopées de manière à former des composants électroniques, en particulier des transistors. Similairement, la couche 38 de la partie A-A, B-B est dopée de manière à former les régions 22a, 22b et 22c.

Les étapes de dopages comprennent par exemple la formation et le retrait de masques, par exemple des masques de lithophotographie. Ces étapes entraînent le retrait partiel du matériau de la couche 58 et des tranchées peu profondes. Ainsi, la couche 58 est retirée au cours de ces étapes. De préférence, l'épaisseur de la couche 58 est telle que la couche 58 est entièrement retirée. Les portions de la couches 54, et par exemple les portions de la couche 55, situées sur les tranchées 20 ne sont pas retirées. De plus, la hauteur des tranchées peu profondes, en particulier les tranchées 18 de la matrice mémoire, est diminuée par les étapes de formation et de retrait de masques.

Les bandes 26 sont ensuite formées sur les portions de la couche 54 ou 55 situées sur les tranchées 20. La couche 28, non représentée en figure 3H, en silicium polycristallin est ensuite formée sur la structure.

La présence, et le maintien, des portions de la couche 54 permettent de diminuer la distance entre les portions 26a et 26b des bandes 26 (figures 2A et 2B). Ainsi, les plans inférieur et supérieur, c'est-à-dire les parties 26a et 26b, sont séparés par une distance D3, inférieure à la distance D1. Autrement dit, les faces supérieures des tranchées 18 et 20 sont séparées par la distance D3. La distance D3 est par exemple inférieure à 10 nm. De plus, les portions 26a sont plus fortement séparées des régions 22c, ce qui permet d'éviter les fuites de courant.

Les cellules mémoire sont ensuite formées sur les régions 22c. En particulier, des vias 13 sont ensuite formés sur les régions 22c.

Divers modes de réalisation et variantes ont été décrits. La personne du métier comprendra que certaines caractéristiques de ces divers modes de réalisation et variantes pourraient être combinées, et d'autres variantes apparaîtront à la personne du métier. En particulier, bien que les figures représentent un dispositif comprenant une partie SOI comprenant des composants électroniques formés dans et sur un substrat de type SOI et une partie BK comprenant des composants électroniques formés dans et sur un substrat massif, le dispositif peut ne comprendre que la partie BK ou que la partie SOI, en addition de la partie A-A, B-B comprenant la matrice mémoire.

Enfin, la mise en oeuvre pratique des modes de réalisation et variantes décrits est à la portée de la personne du métier à partir des indications fonctionnelles données ci-dessus.

## Revendications

1. Procédé de fabrication d'un dispositif comprenant une première partie (A-A, B-B) dans laquelle est formée une matrice de cellules mémoire et une deuxième partie (SOI) dans laquelle sont formés des transistors, chaque cellule mémoire étant située sur une région (22c) d'un substrat, le procédé comprenant les étapes suivantes :
a. la formation de premières tranchées isolantes (20) séparant les unes des autres les régions (22c) de substrat d'une même ligne de cellules, et
b. la formation de deuxièmes tranchées (18) séparant les unes des autres les régions (22c) de substrat d'une même colonne de cellules, les deuxième tranchées (18) ayant une hauteur supérieure à la hauteur des premières tranchées (20),
l'étape a. comprenant les étapes suivantes :
a1. la formation d'une partie inférieure (40) de chaque première tranchée (20), et
a2. la formation d'une partie supérieure (46, 54) de chaque première tranchée,
la formation des parties supérieures (46, 54) comprenant le dépôt d'une première couche isolante (46, 54), la gravure des portions de la première couche (46, 54) isolante n'étant pas situées sur les parties inférieures.

2. Procédé selon la revendication 1, dans lequel le substrat est de type substrat sur isolant dans la deuxième partie (SOI) du dispositif.

3. Procédé selon la revendication 1 ou 2, dans lequel le procédé comprend, avant les étapes a. et b., une étape c. de retrait, dans la première partie, de la couche supérieure de semiconducteur (42) d'un substrat de type substrat sur semiconducteur et la croissance du matériau isolant de la couche intermédiaire (40) isolante du substrat de type substrat sur semiconducteur sur une hauteur au moins égale à la hauteur de la couche supérieure de semiconducteur (42) du substrat, la couche intermédiaire (40) étant en un premier matériau isolant.

4. Procédé selon la revendication 3, dans lequel le procédé comprend, avant les étapes a. et b. et après l'étape c., l'étape d. de formation de la première couche (46, 54) sur les première (A-A, B-B) et deuxième (SOI) parties.

5. Procédé selon la revendication 4, dans lequel l'étape a2. comprend la formation de premières ouvertures dans la première couche (46) en regard des emplacements des régions (22c), et l'étape a1. comprend la gravure de la couche intermédiaire (40) à travers les premières ouvertures, l'étape a2. comprenant, après l'étape a1, le retrait des portions de la première couche (46) situées dans la deuxième partie (SOI), la première couche étant en un deuxième matériau isolant.

6. Procédé selon la revendication 4, dans lequel l'étape a2. comprend le retrait des portions de la première couche (54) situées hors de la première partie (A-A, B-B) et le retrait des portions de la couche intermédiaire (40) et de la première couche (54) situées aux emplacements des premières tranchées (20), la première couche étant en le premier matériau isolant.

7. Procédé selon la revendication 5 ou 6, dans lequel le procédé comprend, après l'étape a. et avant l'étape b., une étape e. de croissance de la couche inférieure (38) du substrat de type semiconducteur sur isolant aux emplacements des régions (22c).

8. Procédé selon la revendication 7, dans lequel le procédé comprend, après l'étape e., une étape f. de formation d'un empilement comprenant une deuxième couche (48, 58) en le premier matériau et une troisième couche (50, 60) en le deuxième matériau sur les première et deuxième parties.

9. Procédé selon la revendication 8, dans lequel les premier et deuxième matériaux sont gravables sélectivement l'un par rapport à l'autre.

10. Procédé selon la revendication 8 ou 9, dans lequel le premier matériau est de l'oxyde de silicium et le deuxième est du nitrure de silicium.

11. Procédé selon l'une quelconque des revendications 8 à 10, dans lequel l'étape b. comprend, après l'étape f., la formation de deuxièmes ouvertures dans la troisième couche (50, 60) de l'empilement en regard des emplacements des deuxièmes tranchées (18), la formation de cavités à travers les deuxièmes ouvertures, et la formation, sur les première et deuxièmes parties, d'une quatrième couche (52, 62) en le premier matériau suffisamment épaisse pour remplir les cavités.

12. Procédé selon la revendication 11, dans lequel le procédé comprend, après l'étape b, une étape g. de retrait par polissage mécano-chimique des portions de la quatrième couche (52, 62) situées au-dessus de la troisième couche (50, 60) de l'empilement et une étape h. de retrait de la troisième couche (50, 60).

13. Procédé selon la revendication 12, dans lequel le procédé comprend, après l'étape h., des étapes de dopage du substrat.

14. Procédé selon l'une quelconque des revendications 1 à 13, dans lequel le procédé comprend le dépôt de bandes de silicium sur les parties supérieures des premières tranchées.

15. Dispositif comprenant une première partie (A-A, B-B) dans laquelle est disposée une matrice de cellules mémoire et une deuxième partie (SOI) dans laquelle sont disposés des transistors, chaque cellule mémoire étant située sur une région (22c) d'un substrat, le dispositif comprenant des premières tranchées isolantes (20) séparant les unes des autres les régions (22c) de substrat d'une même ligne de cellules, et des deuxièmes tranchées (18) séparant les unes des autres les régions (22c) de substrat d'une même colonne de cellules, les deuxièmes tranchées (18) ayant une hauteur supérieure à la hauteur des premières tranchées (20), dans lequel les faces supérieures des premières et deuxièmes tranchées sont séparées d'une distance inférieure à 10 nm.

16. Dispositif comprenant une première partie (A-A, B-B) dans laquelle est disposée une matrice de cellules mémoire et une deuxième partie (SOI) dans laquelle sont disposés des transistors, chaque cellule mémoire étant située sur une région (22c) d'un substrat, le dispositif comprenant des premières tranchées isolantes (20) séparant les unes des autres les régions (22c) de substrat d'une même ligne de cellules, et des deuxièmes tranchées (18) séparant les unes des autres les régions (22c) de substrat d'une même colonnes de cellules, les deuxième tranchées (18) ayant une hauteur supérieure à la hauteur des premières tranchées (20), dans lequel chaque première tranchée comprend une partie inférieure en un premier matériau et une partie inférieure en un deuxième matériau différent du premier matériau, les deuxièmes tranchées ne comprenant pas le deuxième matériau.
